# EUROPEAN PATENT SPECIFICATION

(11) **EP 3 522 352 B1**
(45) Date of publication and mention of the grant of the patent: **27.04.2022**
(21) Application number: 17855246.9
(22) Date of filing: 10.05.2017
(51) Int. Cl.: H02M 7/48, G01K 7/00, G01R 31/26, H03K 17/16, H03K 17/18

(54) **ELECTRICAL DEVICE, AND DIAGNOSTIC APPARATUS FOR ELECTRICAL DEVICE**
ELEKTRISCHE VORRICHTUNG UND DIAGNOSEVORRICHTUNG FÜR ELEKTRISCHE VORRICHTUNG
DISPOSITIF ÉLECTRIQUE, ET APPAREIL DE DIAGNOSTIC DESTINÉ À UN DISPOSITIF ÉLECTRIQUE

(30) Priority: 27.09.2016 JP 2016187758
(43) Date of publication of application: 07.08.2019
(73) Proprietor: Hitachi, Ltd., Tokyo 100-8280 (JP)
(72) Inventor: OGAWA, Takashi, Tokyo 100-8280 (JP); SAKURAI, Naoki, Tokyo 100-8280 (JP)
(74) Representative: MERH-IP Matias Erny Reichl Hoffmann Patentanwälte PartG mbB
(86) International application number: PCT/JP2017/017712
(87) International publication number: WO 2018/061287

(56) References cited:
- EP-A1- 2 615 467
- JP-A- H1 141 077
- JP-A- H07 170 724
- JP-A- 2009 225 541
- JP-A- 2016 063 667

## Description

### Technical Field

The present invention relates to an electric device and a diagnostic apparatus for an electric device.

### Background Art

In the abstract of the following PTL 1, as a technique for measuring the junction temperature of an IGBT device, a system "includes a differential unit 21 configured to receive a gate-emitter voltage characteristic of an IGBT device to be measured and to differentiate the gate-emitter voltage characteristic to obtain pulses correlating with edges formed by a Miller plateau phase during a switch-off phase of the IGBT device, a timer unit 23 configured to measure the time delay between the obtained pulses indicating the start and end of the Miller plateau phase during the switch-off phase of the IGBT device, and a junction temperature calculation unit 25 configured to determine the junction temperature of the IGBT device based on the measured time delay".

EP 2 615 467 A1 discloses a system for monitoring in real time the operating state of an IGBT device, in particular for determining a junction temperature and/or a remaining lifetime of an IGBT device, comprising:
- a differential unit for receiving a gate-emitter voltage characteristic of the IGBT device to be measured and for differentiating the gate-emitter voltage characteristic to obtain pulses correlating with edges formed by a Miller plateau phase during a switch-off phase of the IGBT device;
- a timer unit for measuring the time delay between the obtained pulses indicating the start and end of the Miller plateau phase during the switch-off phase of the IGBT device;
- a junction temperature calculation unit for determining the junction temperature and/or the remaining lifetime of the IGBT device based on the measured time delay.

### Citation List

### Patent Literature

PTL 1: JP 2013-142704 A

### Summary of Invention

### Technical Problem

Meanwhile, in order to detect the Miller plateau phase of the IGBT device by the technique of PTL 1, a measurement circuit with high speed and good radio frequency characteristics is necessary. Furthermore, according to the technique of PTL 1, it is necessary to individually detect the Miller plateau phases for the respective IGBT devices, and there has been also a problem that, for example, a device having N IGBT devices needs N measuring circuits, and a large scale circuit is required. The present invention has been made in view of the above problem, and an object of the present invention is to provide an electric device and a diagnostic apparatus for an electric device which are configured to estimate a semiconductor element temperature with a simple configuration.

### Solution to Problem

The aforementioned object is solved by the invention according to the independent claim 1. Further preferred developments are described by the dependent claims. In particular, an electric device includes a plurality of semiconductor elements, a drive circuit which receives a control signal for directing an on state or an off state of the semiconductor element to drive the semiconductor element on the basis of the control signal, a detector which detects a high-frequent switching noise superimposed on a current flowing from the semiconductor element when it is turned off and on, and a deviation time measurement unit which measures a deviation time being a difference between timing at which the control signal directs the off state and a start of the timing at which the switching noise is detected.

A relationship storage unit is provided which stores a relationship between the deviation time and an element temperature being a temperature of the semiconductor element.

Further a temperature estimation unit is provided which estimates the element temperature on the basis of the deviation time and a content stored in the relationship storage unit.

### Advantageous Effects of Invention

According to the present invention, the semiconductor element temperature is estimated with a simple configuration.

### Brief Description of Drawings

[FIG. 1] FIG. 1 is a block diagram of a power conversion system according to an example
[FIG. 2] FIG. 2 is a circuit diagram of a power semiconductor element.
[FIG. 3] FIG. 3 is a cross-sectional view of a power semiconductor element.
[FIG. 4] FIG. 4(a) is a waveform diagram of a control signal, FIG. 4(b) is a waveform diagram of a current, FIG. 4(c) is a waveform diagram of switching noise, FIG. 4(d) is a waveform diagram of a pulse signal, FIG. 4(e) is a signal waveform diagram of another pulse signal, and FIG. 4(f) is a characteristic diagram of element temperature, according to an example .
[FIG. 5] FIG. 5 is a graph illustrating test results of a power cycle test.
[FIG. 6] FIG. 6 is a block diagram of a power conversion system according to a third embodiment.
[FIG. 7] FIG. 7 is a block diagram of a power conversion monitoring system according to a Z sixth embodiment.
[FIG. 8] FIG. 8 is a view of an example display screen displayed by a server machine. Description of example and embodiments

### Example <Configuration of example

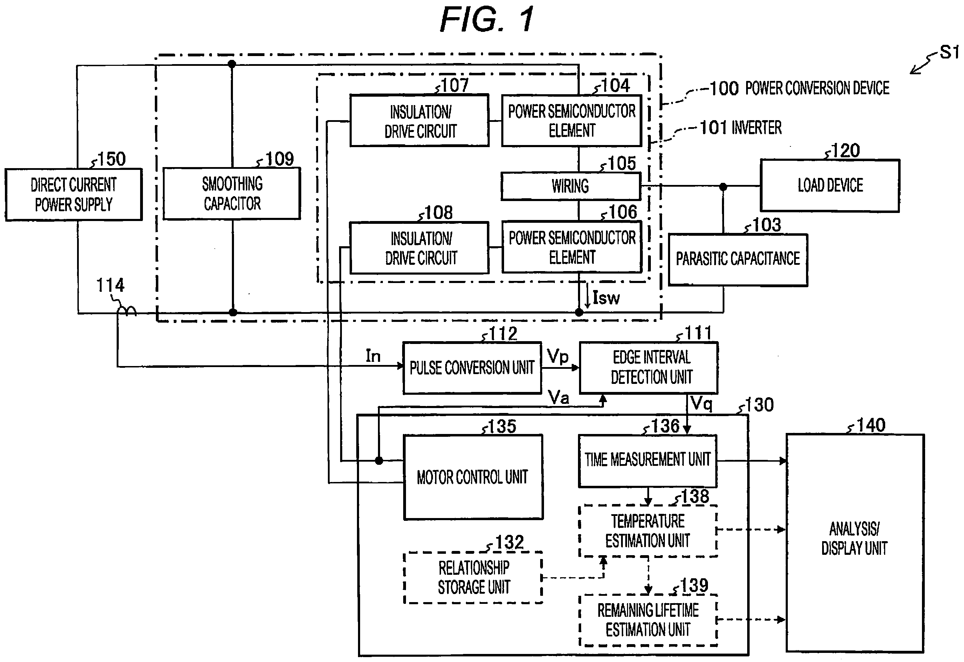

FIG. 1 is a block diagram of a power conversion system S1 (electric device) according to an example In FIG. 1, the power conversion system S1 includes a direct current power supply 150 (direct current voltage power supply), a power conversion device 100 which converts output voltage from the direct current power supply 150 to alternating current voltage, a load device 120 driven by the power conversion device 100, a control unit 130, and an analysis/display unit 140.

Furthermore, the power conversion device 100 includes an inverter 101 and a smoothing capacitor 109. Here, the smoothing capacitor 109 suppresses voltage fluctuation in the direct current power supply 150 upon switching the inverter 101. A current sensor 114 (detector) is provided between the power conversion device 100 and the direct current power supply 150, and between the current sensor 114 and the control unit 130, a pulse conversion unit 112 and an edge interval detection unit 111 (deviation time measurement unit) are provided.

Furthermore, the inverter 101 includes power semiconductor elements 104 and 106 and insulation/drive circuits 107 and 108 (drive circuits) for driving them. Incidentally, the insulation/drive circuits 107 and 108 have a function of driving the power semiconductor elements 104 and 106 while insulating the power semiconductor elements 104 and 106 from the control unit 130. As a result, the inverter 101 pulse-width modulates (PWM) direct current voltage output from the direct current power supply 150 to generate alternating current voltage and supplies the alternating current voltage to the load device 120.

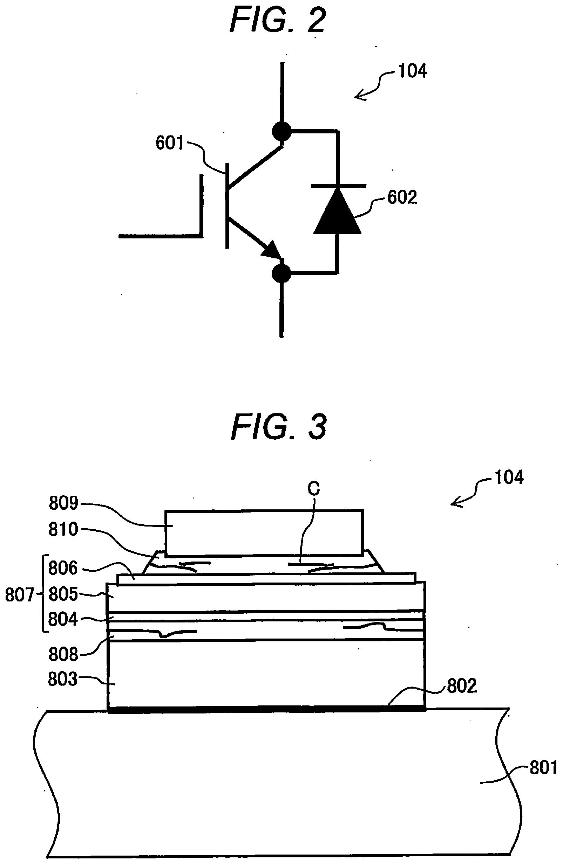

FIG. 2 is a circuit diagram of the power semiconductor element 104. As illustrated in FIG. 2, the power semiconductor element 104 includes an IGBT 601 and a diode 602 which is reversely connected. Note that the IGBT 601 may be replaced with a metal-oxide-semiconductor field-effect transistor (MOSFET). When a parasitic diode of a MOSFET can be applied instead of the diode 602, the diode 602 may be omitted. Although the configuration of the power semiconductor element 104 has been described above, the power semiconductor element 106 also has the same configuration.

FIG. 3 is a cross-sectional view of the power semiconductor element 104. The power semiconductor element 104 includes a base plate 803, a solder layer 808, an insulated substrate 807, a solder layer 810, and a semiconductor element unit 809. In addition, the insulated substrate 807 includes a metal layer 804, an insulation layer 805, and a metal layer 806. The base plate 803 is made abut on a cooler 801, and grease 802 is applied to the abutting surface. Note that the power semiconductor element 106 is also configured similarly to the power semiconductor element 104.

In FIG. 3, only one semiconductor element unit 809 is illustrated, but in a semiconductor module for high power applications to produce output power of megawatt level, a large number of semiconductor element units 809 are often mounted in parallel. During operation of the power conversion system S1, heat generated in the semiconductor element unit 809 is transferred to the insulated substrate 807, the base plate 803, the grease 802, and the cooler 801 via the solder layer 810.

Here, the temperature of the power semiconductor element 809 may become abnormally high due to depletion of grease 802, failure of the cooler 801, abnormal operation or failure of the control unit 130 (see FIG. 1), or the like. When the temperature of the power semiconductor element 809 becomes abnormally high, cracks C, peeling, or the like occurs in the solder layers 808 and 810 due to thermal fatigue caused by temperature cycle. Then, thermal resistance in the solder layers 808 and 810 becomes high, and cracks C, peeling, or the like grows, causing accumulated deterioration. Consequently, the channel resistance of the power semiconductor element 809 finally burns out and the power semiconductor element 104 or 106 is broken.

Therefore, it is desirable to detect an abnormality before breakage by monitoring the temperature of the power semiconductor elements 104 and 106. In order to increase the accuracy in temperature detection, it is desirable to measure the surface temperature of the semiconductor element unit 809. Even if the temperature of the back surface of the power semiconductor element 809 or the temperature of the base plate 803 are measured, respective thermal time constants are added, and it is difficult to measure an accurate temperature change.

Returning to FIG. 1, the inverter 101 is a half-bridge inverter, and the power semiconductor elements 104 and 106 are connected in series, and direct current voltage is applied from the direct current power supply 150 to both ends of these series circuits. In addition, the power semiconductor elements 104 and 106 are connected via the wiring 105, and the wiring 105 is connected to the load device 120.

Switching current from the power semiconductor elements 104 and 106 is supplied to the load device 120 via the wiring 105. Here, since a parasitic inductance is in the wiring 105 and a parasitic capacitance 103 is between the wiring 105 and a grounding point E, the switching noise (noise component) is superimposed on current flowing in the wiring 105. This switching noise is generated at timing of turning off and turning on the power semiconductor elements 104 and 106, and in particular, timing of generation of turning off has temperature dependency.

The current sensor 114 detects the switching noise In from current Isw flowing from the inverter 101 to the direct current power supply 150. The pulse conversion unit 112 outputs a pulse signal Vp (square wave pulse) on the basis of the switching noise In, and the edge interval detection unit 111 outputs a pulse signal Vq on the basis of the pulse signal Vp. Details of the pulse signals Vp and Vq will be described later.

The control unit 130 includes hardware as a general computer, such as a central processing unit (CPU), a random access memory (RAM), a read only memory (ROM). The ROM stores control programs executed by the CPU, various data, and the like. In FIG. 1, on the inside of the control unit 130, functions achieved by the control programs and the like are shown as a block.

That is, the control unit 130 includes a motor control unit 135 and a time measurement unit 136 (deviation time measurement unit). The motor control unit 135 controls a motor (not illustrated) included in the load device 120 by controlling the switching timing of the power semiconductor elements 104 and 106. Note that a relationship storage unit 132 and a temperature estimation unit 138 are part of the first embodiment. The remaining lifetime estimation unit is applied to other embodiments described later.

The analysis/display unit 140 is, for example, a personal computer, and includes hardware, such as a CPU, a RAM, a ROM, and a hard disk drive (HDD). The analysis/display unit 140 analyzes results output from the time measurement unit 136 and the like, and displays a result of the analysis.

### <Operation of an example>

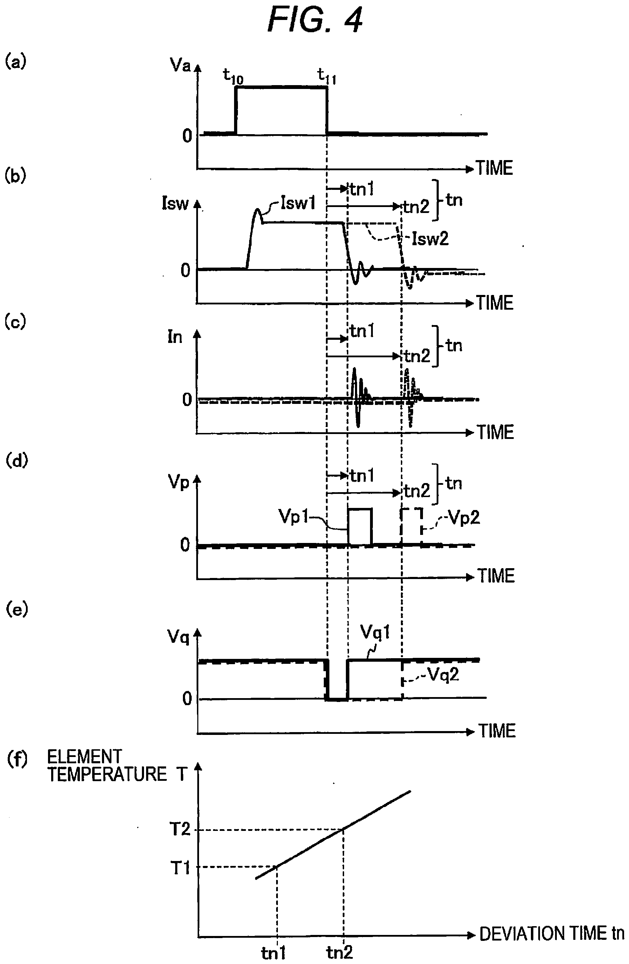

Next, the operation of an example will be described with reference to FIGS. 4(a) to 4(f). FIGS. 4(a) to 4(e) are waveform diagrams illustrating control signal Va, current Isw, switching noise In, pulse signal Vp, and pulse signal Vq. FIG. 4(f) is a characteristic diagram illustrating the temperature (hereinafter referred to as an element temperature T) of the semiconductor element unit 809 (see FIG. 2).

The control signal Va is a signal supplied from the motor control unit 135 to the insulation/drive circuit 107 or 108. The waveform of the control signal Va has a square waveform as illustrated in FIG. 4(a), rises at time t10, and falls at time t11. When the insulation/drive circuit 107 or 108 drives the power semiconductor element 104 or 106 by using this control signal Va, a current Isw illustrated in FIG. 4(b) flows through the power semiconductor element 104 or 106. The waveform of the current Isw has such a waveform that the fall timing is delayed and ringing occurs with respect to the waveform of the control signal Va of FIG. 4(a).

In FIG. 4(b), the waveforms of currents Isw1 and Isw2 at element temperatures T1 and T2 (where T1 < T2) are represented as the current Isw by a solid line and a broken line. Delay time at the fall of the current Isw is referred to as "deviation time tn". Furthermore, the deviation time of the current Isw1 is referred to as tn1 and the deviation time of the current Isw2 is referred to as tn2. Thus, the deviation time tn becomes longer as the element temperature T becomes higher. This is because discharging time at a junction of the power semiconductor element 104 or 106 becomes longer as the element temperature T becomes higher.

Next, as illustrated in FIG. 4(c), the switching noise In has a waveform approximating a ringing waveform of the current Isw, that is, a radio frequency component. Time periods from time t11 to the start of ringing are deviation times tn1 and tn2 described above. Next, pulse signals Vp1 and Vp2 in FIG. 4(d) are pulse signals Vp at element temperatures T1 and T2. The pulse signal Vp has a waveform rising when the envelope level of the switching noise In exceeds a predetermined value and falling when the envelope level of the switching noise In falls below the predetermined value.

Next, pulse signals Vq1 and Vq2 in FIG. 4(e) are pulse signals Vq at element temperatures T1 and T2. The pulse signal Vq is a signal falling to zero at timing at which the control signal Va falls, that is, at time t11 and rising at timing at which the pulse signal Vp rises. Therefore, as illustrated in FIG. 4, the lengths of periods during which the pulse signals Vq are zero are equal to deviation times tn (i.e., tn1 and tn2).

The time measurement unit 136 (see FIG. 1) in the control unit 130 measures the deviation time tn by measuring a time period during which the pulse signal Vq is zero. The analysis/display unit 140 in FIG. 1 stores a relationship between the deviation time tn and the element temperature T as illustrated in FIG. 4(f) in the form of a table or a function. Thus, when the deviation time tn is supplied from the time measurement unit 136, the analysis/display unit 140 calculates an estimated value of the element temperature T.

Here, the ambient temperature of the motor control unit 135 is not affected by the ambient temperatures of the power semiconductor elements 104 and 106, and the ambient temperature of the motor control unit 135 is substantially constant. Therefore, measuring timing of generating the switching noise In enables measuring a time period required for the turning off the power semiconductor elements based on the control signal Va, as the deviation times tn1 and tn2 described above. The switching noise In is caused by any of the power semiconductor elements 104 and 106. However, since the falling timing (time t11 in FIG. 4) of the control signals Va supplied to the power semiconductor elements 104 and 106 are different, the control unit 130 determines whether the generated switching noise In is caused by which of the power semiconductor elements 104 and 106, on the basis of these control signals Va.

### <Effects of the example>

As described above, according to the present example, it is possible to measure the element temperatures T of the power semiconductor elements 104 and 106 with a simple configuration. Furthermore, the circuits, such as the current sensor 114, the pulse conversion unit 112, and the edge interval detection unit 111, can be shared between the power semiconductor elements 104 and 106, and the element temperatures T of the power semiconductor elements 104 and 106 can be measured with a further small scale circuit.

### [First embodiment]

Next, referring to FIG. 1 again, a configuration of a power conversion system according to a first embodiment of the present invention will be described. In the present embodiment, the control unit 130 includes the relationship storage unit 132 and the temperature estimation unit 138 represented by the broken lines in FIG. 1. The relationship storage unit 132 stores the relationship between the deviation time tn and the element temperature T illustrated in FIG. 4(f), in the form of a table or a function.

Then, the temperature estimation unit 138 determines an estimated value of the element temperature T on the basis of the contents stored in the relationship storage unit 132 and a deviation time tn supplied from a time measurement unit 136, and supplies the estimated value to the analysis/display unit 140. In the present embodiment, the configurations and operations other than those described above are similar to those of the first embodiment. Thus, according to the present embodiment, the same effects as those of the example can be obtained. Furthermore, according to the present embodiment, the control unit 130 is configured to determine an estimated value of the element temperature T in real time.

### [Second embodiment]

Next, referring to FIG. 1 again, a configuration of a power conversion system according to a second embodiment of the present invention will be described. In the present embodiment, the control unit 130 includes the remaining lifetime estimation unit 139, in addition to the relationship storage unit 132 and the temperature estimation unit 138 represented by the broken lines in FIG. 1. The remaining lifetime estimation unit 139 has a function of estimating the remaining lifetimes of the power semiconductor elements 104 and 106. Configurations other than the configurations described above are similar to those of the first embodiment.

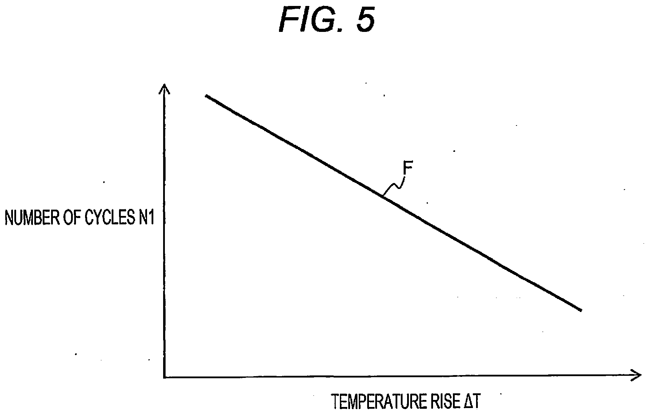

Here, the principle of estimating the remaining lifetimes of the power semiconductor elements 104 and 106 by the remaining lifetime estimation unit 139 will be described. FIG. 5 is a graph illustrating test results of a power cycle test. It is assumed that "one cycle" is an operation of "returning temperature to the original temperature by giving a certain temperature rise ΔT" to a power semiconductor element 104 or 106, and it is assumed that when this operation is performed for N1 cycles, the power semiconductor element 104 or 106 breaks down. When an element temperature before temperature rise is T01 and an element temperature after the temperature rise is T02, a temperature rise ΔT is equal to "T02-T01". Measuring the number of cycles N1 for various temperature rises ΔT is referred to as "power cycle test", and a characteristic F illustrated in FIG. 5 is the results of the measurements. Note that FIG. 5 is a graph in which both the vertical and horizontal axes are log scale, and the vertical axis represents the number of cycles N1 and the horizontal axis represents temperature rise ΔT.

Here, the stress S of a power semiconductor element 104 or 106 when a certain temperature rise ΔT occurs once is defined as "S = 1/N1". Let a time period required to hold the element temperature T02 be th seconds, it can be assumed that the lifetime LF of a power semiconductor element 104 or 106 expires in "LF = th/S" seconds. Then, when already consumed lifetime is subtracted from a predicted remaining lifetime of a new power semiconductor element 104 or 106, the remaining lifetime can be predicted.

The remaining lifetime estimation unit 139 in FIG. 1 stores the characteristic F illustrated in FIG. 5, predicts the stress S and the lifetime LF on the basis of the characteristic F, and on the basis of such prediction results, the remaining lifetimes of the power semiconductor element 104 and 106 are predicted. According to the present embodiment, as in the first embodiment, since the element temperature T can be obtained with high accuracy, the remaining lifetimes of the power semiconductor elements 104 and 106 can also be predicted with high accuracy.

### [Third embodiment]

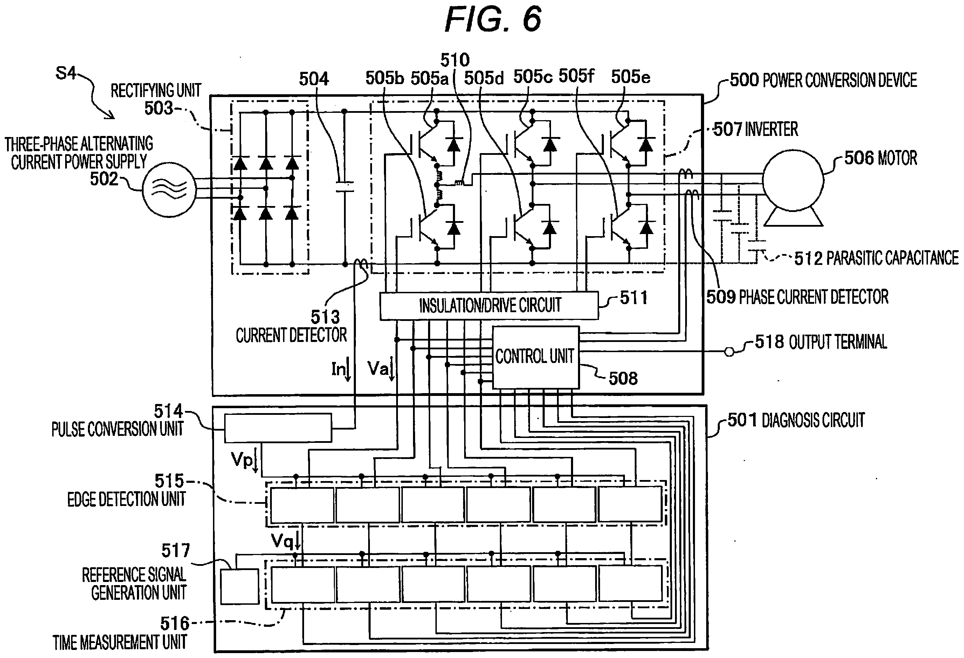

Next, referring to FIG. 6, a configuration of a power conversion system S4 (electric device) according to a third embodiment of the present invention will be described. In FIG. 6, portions corresponding to the respective portions in FIGS. 1 to 5 are denoted by the same reference numerals, and the description thereof may be omitted. In FIG. 6, the power conversion system S4 includes a power conversion device 500, a diagnosis circuit 501, a three-phase alternating current power supply 502, and a three-phase motor 506.

In the power conversion device 500, a rectifying unit 503 rectifies output voltage from the three-phase alternating current power supply 502. A smoothing capacitor 504 smooths the rectified voltage and outputs direct current voltage. That is, the three-phase alternating current power supply 502, the rectifying unit 503, and the smoothing capacitor 504 constitute a direct current voltage power supply. The inverter 507 includes six IGBTS 505a, 505b, 505c, 505d, 505e, and 505f (semiconductor elements). The phase current sensor 509 detects phase current supplied to the three-phase motor 506, and a result of the detection is supplied to the control unit 508.

The control unit 508 includes hardware as a general computer, such as a CPU, a RAM, and a ROM, and the ROM stores control programs executed by the CPU, various data, and the like. The control unit 508 determines on/off timing of the IGBTS 505a to 505f on the basis of a result of the detection of phase current and supplies control signals for directing turning on/off of these IGBTS 505a to 505f to the insulation/drive circuit 511 (drive circuit). Thus, the insulation/drive circuit 511 controls switching on/off of the IGBTS 505a to 505f.

A wiring inductance 510, a parasitic capacitance 512, and the like are in a transmission line connecting the inverter 507 and the three-phase motor 506. A current sensor 513 (detector) is mounted in a transmission line between the smoothing capacitor 504 and the inverter 507. The current sensor 513 detects switching noise In from current flowing from the inverter 507 to the rectifying unit 503.

A pulse conversion unit 514 in the diagnosis circuit 501 outputs a pulse signal Vp according to a noise width of the switching noise In detected by the current sensor 513. The pulse signal Vp output from the pulse conversion unit 514 and control signals Va output from the control unit 508 are supplied to the edge detection unit 515 (deviation time measurement unit). On the basis of output timing of a control signal Va output by the control unit 508 and generation timing of the pulse signal Vp, the edge detection unit 515 determines whether the pulse signal Vp is generated from which of the IGBTS 505a to 505f.

Then, on the basis of the control signal Va and the corresponding pulse signal Vp, the edge detection unit 515 outputs a pulse signal Vq corresponding to a deviation time. Six systems of the pulse signals Vq are output corresponding to the respective IGBTS 505a to 505f. The waveforms of the control signal Va, the switching noise In, and the pulse signals Vp and Vq are similar to those of the example (FIGS. 4(a), 4(c) to 4(e)).

A reference signal generation unit 517 outputs reference clock pulses. A time measurement unit 516 (deviation time measurement unit) continues to output the clock pulses corresponding to each of the six systems of pulse signals Vq within a time period in which a pulse signal Vq is zero. The control unit 508 measures a deviation time tn by counting the clock pulses. Therefore, the deviation times tn of the six systems of the IGBTS 505a to 505f can be acquired. Furthermore, the obtained deviation times tn are output to the outside via an output terminal 518.

As described above, according to the present embodiment, it is possible to measure the element temperatures T of the IGBTS 505a to 505f with a simple configuration as in the example . Further, the circuits, such as the current sensor 513 and the pulse conversion unit 514, can be shared between all the IGBTS 505a to 505f, and the element temperatures T of the IGBTS 505a to 505f can be measured with a further small scale circuit.

### [Fourth embodiment]

Next, a configuration of a power conversion system according to a fourth embodiment of the present invention will be described. The hardware configurations and operations of the present embodiment are similar to those of the third embodiment. However, in the present embodiment, the control unit 508 stores the relationship between the deviation time tn and the element temperature T illustrated in FIG. 4(f), which represents a relationship between deviation time tn and an element temperature T, in the form of a table or a function. Thus, the control unit 508 (see FIG. 6) can obtain the element temperatures T of the IGBTS 505a to 505f during operation of the power conversion device 500. In addition, the control unit 508 according to the present embodiment outputs the determined element temperatures T to the outside via the output terminal 518.

As described above, according to the present embodiment, the same effects as those of the third embodiment can be obtained. Furthermore, by connecting the output terminal 518 to a communication interface (not illustrated), it becomes possible to output the element temperatures T via a communication network, achieving an internet of thing (IoT), such as monitoring of the power conversion device.

### [Fifth embodiment]

Next, a configuration of a power conversion system according to a fifth embodiment of the present invention will be described. The hardware configurations and operations of the present embodiment are similar to those of the fourth embodiment. However, in the present embodiment, the control unit 508 has the same function as that of the remaining lifetime estimation unit 139 (see FIG. 1) in the second embodiment. Thus, the control unit 508 predicts the remaining lifetime of each of the IGBTS 505a to 505f, and outputs the predicted remaining lifetime via the output terminal 518. As described above, according to the present embodiment, the same effects as those of the fourth embodiment can be obtained, and the remaining lifetime of each of the IGBTS 505a to 505f can be predicted with high accuracy as in the second embodiment.

### [Sixth embodiment]

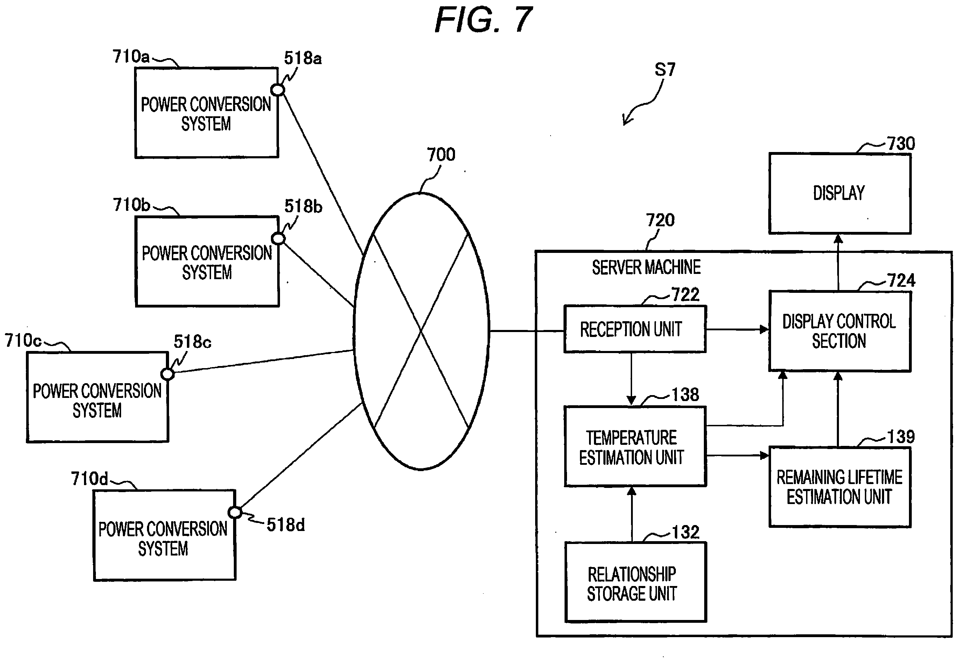

Next, a configuration of a power conversion monitoring system S7 according to a sixth embodiment of the present invention will be described with reference to FIG. 7. In FIG. 7, portions corresponding to the respective portions in FIGS. 1 to 6 are denoted by the same reference numerals, and the description thereof may be omitted. In FIG. 7, the power conversion monitoring system S7 includes power conversion systems 710a, 710b, 710c, and 710d and a server machine 720 (a diagnostic apparatus for an electric device). The power conversion systems 710a, 710b, 710c, and 710d and the server machine 720 are mutually communicable via a communication network 700.

The server machine 720 includes hardware as a general computer, such as a CPU, a RAM, a ROM, and an HDD, and the HDD stores an operating system (OS), application programs, various data, and the like. The OS and each application program are loaded in the RAM and executed by the CPU. In FIG. 7, on the inside of the server machine 720, functions achieved by the control programs and the like are shown as a block.

The power conversion systems 710a to 710d (electric devices) are any of the power conversion systems according to the third to fifth embodiments. As described above, the power conversion system according to the third to fifth embodiments includes the output terminal 518 (see FIG. 6). In FIG. 7, the output terminals 518 of the power conversion systems 710a to 710d are denoted by 518a to 518d. As illustrated in FIG. 7, the power conversion systems 710a to 710d are connected to the communication network 700 via output terminals 518a to 518d.

The server machine 720 includes a reception unit 722, a display control unit 724, the relationship storage unit 132, the temperature estimation unit 138, and the remaining lifetime estimation unit 139. Here, the contents of the relationship storage unit 132, the temperature estimation unit 138, and the remaining lifetime estimation unit 139 are the same as those of the second embodiment (see FIG. 1). The reception unit 722 collects deviation time tn, element temperature T, and/or predicted remaining lifetime from the power conversion systems 710a to 710d via the communication network 700.

When the power conversion systems 710a to 710d are the power conversion system S4 according to the third embodiment, the deviation time tn is supplied from the power conversion systems 710a to 710d, but the element temperature T and the predicted remaining lifetime are not supplied. Therefore, in such a case, the server machine 720 estimates the element temperature T and the predicted remaining lifetime by using the temperature estimation unit 138, the relationship storage unit 132, and the remaining lifetime estimation unit 139.

When the power conversion systems 710a to 710d are the power conversion system according to the fourth embodiment, the deviation time tn and the element temperature T are supplied from the power conversion systems 710a to 710d, but the predicted remaining lifetime is not supplied. Therefore, in such a case, the remaining lifetime estimation unit 139 estimates the predicted remaining lifetime. When the power conversion systems 710a to 710d are the power conversion system according to the fifth embodiment, both the element temperature T and the predicted remaining lifetime are supplied from the power conversion systems 710a to 710d. The display control unit 724 displays the element temperature T and the predicted remaining lifetime and the like on a display 730.

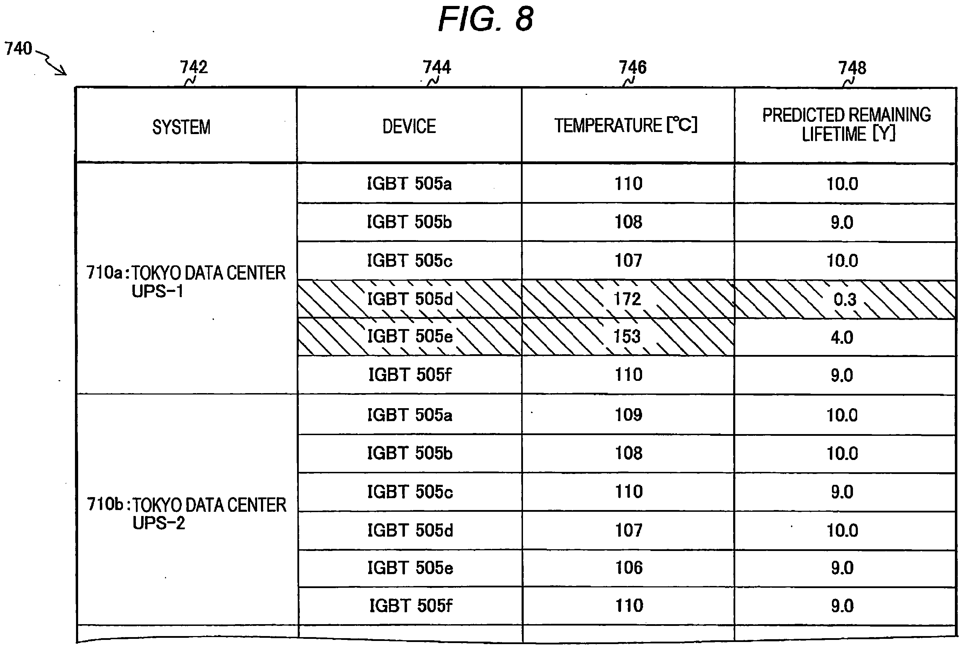

FIG. 8 is a diagram illustrating an example of a display screen 740 displayed on the display 730 by the display control unit 724. In FIG. 8, the display screen 740 has a system column 742, a device column 744 (device information), a temperature column 746, and a predicted remaining lifetime column 748. The system column 742 displays information for identifying any one of the power conversion systems (710a to 710d) as a target. Further, the device column 744 displays information for identifying any one of the devices (for example, the IGBTS 505a to 505f) included in a corresponding power conversion system.

In addition, the temperature column 746 displays the element temperatures T of the devices. Further, the predicted remaining lifetime column 748 displays the predicted remaining lifetimes of one year of the devices. Further, when the element temperature T displayed is equal to or more than a predetermined value (for example, 150°C or higher), the display control unit 724 sets the display mode of a corresponding portion of the temperature column 746 to a predetermined warning display mode. In FIG. 8, the portion of the temperature column set as the warning display mode is displayed by hatching. Actually, for example, a background color is desirably set to "white" in a normal display mode, and a background color is desirably set to "red" in the warning display mode.

Further, when the predicted remaining lifetime is equal to or less than a predetermined value (for example, one year or less), the display control unit 724 sets the display mode of a corresponding portion of the predicted remaining lifetime column 748 to a warning display mode. Further, when at least one of the temperature column 746 or the predicted remaining lifetime column 748 corresponding to a certain device is set to the warning display mode, the display control unit 724 also sets the display mode of a portion of the device column 744 corresponding the device to the warning display mode.

In the illustrated example, portions of the temperature column 746 corresponding to the IGBTS 505d and 505e of the power conversion system 710a and a portion of the predicted remaining lifetime column 748 corresponding to the IGBT 505d are set to the warning display mode, and accordingly, portions of the device column 744 corresponding to the IGBTS 505d and 505e of the power conversion system 710a are set to the warning display mode. Thus, a user of the server machine 720 looking at the display screen 740 can immediately understand that the IGBTS 505d and 505e of the power conversion system 710a should be replaced.

As described above, according to the present embodiment, the same effects as those of the third to fifth embodiments can be obtained, and the user can be easily notified of immediate replacement of any of a large number of devices.

### [Modifications]

The present invention is not limited to the above-described embodiments, but is defined solely by the appended claims. For example, the above embodiments are exemplified for ease of understanding the present invention, and therefore, the present invention is not necessarily limited to a configuration including all of the configurations described above. Furthermore, part of a configuration of an embodiment can be replaced with a configuration of another embodiment, and a configuration of an embodiment can be added to a configuration of another embodiment. Still furthermore, some of the configurations of the respective embodiments may be eliminated or another configuration may be added or substituted. Still another furthermore, in the figures, the control lines or information lines considered to be necessary for description are described, and all control lines or information lines required for a product are not always illustrated. In practice, it can be considered that almost all the configurations are mutually connected. Possible modifications of the above embodiments are, for example, as follows.

(1) In the above embodiments, examples of application of the power conversion system as the "electric device" have been described, but the electric device is not limited thereto. That is, all devices including semiconductor elements, such as various power supply devices, refrigerators, washing machines, vacuum cleaners, industrial machines, electric vehicles, railroad vehicles, ships, elevators, escalators, are included in the "electric device".
(2) The hardware of the control unit 130, the analysis/display unit 140, the control unit 508, and the server machine 720 in the above embodiments can be achieved by a general computer, and programs and the like for executing these processes may be stored in a storage medium or may be distributed via a transmission line.
(3) Processing of the control unit 130, the analysis/display unit 140, the control unit 508, and the server machine 720 in the above embodiments has been described as software processing using programs in the above embodiments, but may be partially or wholly replaced with hardware processing using application specific integrated circuit (ASIC), field-programmable gate array (FPGA), or the like.
(4) In the above embodiments, component elements (for example, the relationship storage unit 132, the temperature estimation unit 138, the analysis/display unit 140 in FIG. 1) for determining the element temperature T on the basis of the deviation time tn are provided, but such component elements are not necessarily provided. That is, on the basis of measured deviation time tn, the user who is a human may calculate the element temperature T. In such a configuration as well, the user can estimate a semiconductor element temperature with a simple configuration.

### Reference Signs List

104, 106 power semiconductor element (semiconductor element)
107, 108 insulation/drive circuit (drive circuit)
111 edge interval detection unit (deviation time measurement unit)
112 pulse conversion unit
114 current sensor (detector)
132 relationship storage unit
136 time measurement unit (deviation time measurement unit)
138 temperature estimation unit
139 remaining lifetime estimation unit
150 direct current power supply (direct current voltage power supply)
502 three-phase alternating current power supply (direct current voltage power supply)
503 rectifying unit (direct current voltage power supply)
504 smoothing capacitor (direct current voltage power supply)
505a to 505f IGBT (semiconductor element)
511 insulation/drive circuit (drive circuit)
513 current sensor (detector)
515 edge detection unit (deviation time measurement unit)
516 time measurement unit (deviation time measurement unit)
700 communication network
710a to 710d power conversion system (electric device)
720 server machine (diagnostic apparatus for electric device)
722 reception unit
724 display control unit
730 display
744 device column (device information)
S1, S4 power conversion system (electric device)
S7 power conversion monitoring system (electric device)
T element temperature
In switching noise (noise component)
Va control signal
Vp1, Vp2, Vp pulse signal (square wave pulse)
tn1, tn2 deviation time

## Claims

1. An electric device comprising: at least one semiconductor element (104, 106);
a drive circuit (107, 108) configured to receive a control signal for directing an on state or an off state of the semiconductor element (104, 106) to drive the semiconductor element (104, 106) on the basis of the control signal;
a direct current voltage power supply (150) configured to provide output power to the semiconductor element (104, 106);
a detector (114) configured to detect a high-frequency switching noise generated in the semiconductor element (104, 106) when it is turned off and on, and superimposed on a current flowing from the semiconductor element (104, 106);
a deviation time measurement unit (111) configured to measure a deviation time being a difference between timing at which the control signal directs the off state and timing at which start of the switching noise is detected;
a relationship storage unit (132) configured to store a relationship between the deviation time and an element temperature being a temperature of the semiconductor element (104, 106); and
a temperature estimation unit (138) configured to estimate the element temperature on the basis of the deviation time and a content stored in the relationship storage unit (132).

2. The electric device according to claim 1 further comprising
a remaining lifetime estimation unit (139) configured to estimate a predicted remaining lifetime of the semiconductor element (104, 106) on the basis of the element temperature.

3. The electric device according to claim 2 further comprising
a pulse conversion unit (112) configured to convert the switching noise into a square wave pulse,
wherein the deviation time measurement unit (111) is configured to measure the deviation time on the basis of timing at which the control signal changes and timing at which the square wave pulse changes.

4. The electric device according to claim 3, further comprising
a plurality of the semiconductor elements (104, 106); and
a display control unit (724) configured to display, on a display, device information being information for identifying a plurality of the semiconductor elements (104, 106), the element temperature relating to each of the semiconductor elements (104, 106), and the predicted remaining lifetime relating to each of the semiconductor elements (104, 106),
wherein the display control unit (724) is configured to display the device information of any of the semiconductor elements (104, 106), the element temperature of which is equal to or higher than a predetermined temperature, in a display mode different from the device information of the other semiconductor elements (104, 106).

## Patentansprüche

1. Elektrische Vorrichtung, die Folgendes umfasst:
mindestens ein Halbleiterelement (104, 106);
eine Ansteuerschaltung (107, 108), die konfiguriert ist, ein Steuersignal zum Anweisen eines Ein-Zustands oder eines Aus-Zustands des Halbleiterelements (104, 106) zu empfangen, um das Halbleiterelement (104, 106) auf der Grundlage des Steuersignals anzusteuern;
eine Gleichspannungs-Energieversorgung (150), die konfiguriert ist, für das Halbleiterelement (104, 106) eine Ausgangsleistung bereitzustellen;
einen Detektor (114), der konfiguriert ist, ein hochfrequentes Schaltrauschen zu detektieren, das im Halbleiterelement (104, 106) erzeugt wird, wenn es aus- und eingeschaltet wird, und einem Strom, der aus dem Halbleiterelement (104, 106) fließt, überlagert wird;
eine Abweichungszeit-Messeinheit (111), die konfiguriert ist, eine Abweichungszeit, die eine Differenz zwischen einem Zeitpunkt, zu dem das Steuersignal den Aus-Zustand anweist, und einem Zeitpunkt, zu dem der Beginn des Schaltrauschens detektiert wird, zu messen;
eine Beziehungsspeichereinheit (132), die konfiguriert ist, eine Beziehung zwischen der Abweichungszeit und einer Elementtemperatur, die eine Temperatur des Halbleiterelements (104, 106) ist, zu speichern; und
eine Temperaturschätzeinheit (138), die konfiguriert ist, die Elementtemperatur auf der Grundlage der Abweichungszeit und eines Inhalts, der in der Beziehungsspeichereinheit (132) gespeichert ist, zu schätzen.

2. Elektrische Vorrichtung nach Anspruch 1, die ferner Folgendes umfasst:
eine Restlebensdauer-Schätzeinheit (139), die konfiguriert ist, auf der Grundlage der Elementtemperatur eine vorhergesagte Restlebensdauer des Halbleiterelements (104, 106) zu schätzen.

3. Elektrische Vorrichtung nach Anspruch 2, die ferner Folgendes umfasst:
eine Pulsumsetzungseinheit (112), die konfiguriert ist, das Schaltrauschen in einen Rechteckwellenpuls umzusetzen,
wobei die Abweichungszeit-Messeinheit (111) konfiguriert ist, die Abweichungszeit auf der Grundlage des Zeitpunkts, zu dem sich das Steuersignal ändert, und des Zeitpunkts, zu dem sich der Rechteckwellenpuls ändert, zu messen.

4. Elektrische Vorrichtung nach Anspruch 3, die ferner Folgendes umfasst:
mehrere Halbleiterelemente (104, 106); und
eine Anzeigesteuereinheit (724), die konfiguriert ist, auf einer Anzeige Vorrichtungsinformationen, die Informationen zum Identifizieren mehrerer der Halbleiterelemente (104, 106) sind, die Elementtemperatur, die sich auf jedes der Halbleiterelemente (104, 106) bezieht, und die vorhergesagte Restlebensdauer, die sich auf jedes der Halbleiterelemente (104, 106) bezieht, anzuzeigen,
wobei die Anzeigesteuereinheit (724) konfiguriert ist, die Vorrichtungsinformationen jedes der Halbleiterelemente (104, 106), dessen Elementtemperatur größer oder gleich einer vorgegebenen Temperatur ist, in einer Anzeigebetriebsart anzuzeigen, die sich von jener der Vorrichtungsinformationen der anderen Halbleiterelemente (104, 106) unterscheidet.

## Revendications

1. Dispositif électrique comprenant :
au moins un élément semi-conducteur (104, 106) ;
un circuit pilote (107, 108) configuré pour recevoir un signal de commande destiné à diriger un état de marche ou un état d'arrêt de l'élément semi-conducteur (104, 106) pour entraîner l'élément semi-conducteur (104, 106) sur la base du signal de commande ;
une alimentation de puissance en tension à courant continu (150) configurée pour fournir une puissance de sortie à l'élément semi-conducteur (104, 106) ;
un détecteur (114) configuré pour détecter un bruit de commutation à haute fréquence généré dans l'élément semi-conducteur (104, 106) quand il est désactivé et activé, et superposé à un courant s'écoulant depuis l'élément semi-conducteur (104, 106) ;
une unité de mesurage de temps de déviation (111) configurée pour mesurer un temps de déviation qui est une différence entre une temporisation à laquelle le signal de commande dirige l'état d'arrêt et une temporisation à laquelle un démarrage du bruit de commutation est détecté ;
une unité de stockage de relation (132) configurée pour stocker une relation entre le temps de déviation et une température d'élément qui est une température de l'élément semi-conducteur (104, 106) ; et
une unité d'estimation de température (138) configurée pour estimer la température d'élément sur la base du temps de déviation et d'un contenu stocké dans l'unité de stockage de relation (132).

2. Dispositif électrique selon la revendication 1, comprenant en outre :
une unité d'estimation de durée de vie restante (139) configurée pour estimer une durée de vie restante prédite de l'élément semi-conducteur (104, 106) sur la base de la température d'élément.

3. Dispositif électrique selon la revendication 2, comprenant en outre :
une unité de conversion d'impulsion (112) configurée pour convertir le bruit de commutation en une impulsion d'onde carrée,
dans lequel l'unité de mesurage de temps de déviation (111) est configurée pour mesurer le temps de déviation sur la base d'une temporisation à laquelle le signal de commande change et d'une temporisation à laquelle l'impulsion d'onde carrée change.

4. Dispositif électrique selon la revendication 3, comprenant en outre :
une pluralité des éléments semi-conducteurs (104, 106) ; et
une unité de commande d'affichage (724) configurée pour afficher, sur un affichage, une information de dispositif qui est une information destinée à identifier une pluralité des éléments semi-conducteurs (104, 106), la température d'élément se rapportant à chacun des éléments semi-conducteurs (104, 106), et la durée de vie restante prédite se rapportant à chacun des éléments semi-conducteurs (104, 106),
dans lequel l'unité de commande d'affichage (724) est configurée pour afficher l'information de dispositif de l'un quelconque des éléments semi-conducteurs (104, 106), dont la température d'élément est égale ou
supérieure à une température prédéterminée, dans un mode d'affichage différent de l'information de dispositif des autres éléments semi-conducteurs (104, 106).
